# EUROPEAN PATENT APPLICATION

(11) **EP 4 343 874 A1**
(43) Date of publication of application: **27.03.2024**
(21) Application number: 22804332.9
(22) Date of filing: 11.03.2022
(51) Int. Cl.: H01L 51/44, H01L 51/46, H01L 31/048

(54) **SOLAR CELL AND METHOD FOR MANUFACTURING SOLAR CELL**

(30) Priority: 21.05.2021 JP 2021086531
(71) Applicant: Panasonic Holdings Corporation, Osaka 571-8501 (JP)
(72) Inventor: HIRAOKA, Maki, Kadoma-shi, Osaka 571-0057 (JP); SEKIMOTO, Takeyuki, Kadoma-shi, Osaka 571-0057 (JP); MATSUI, Taisuke, Kadoma-shi, Osaka 571-0057 (JP); NAKAMURA, Toru, Kadoma-shi, Osaka 571-0057 (JP)
(74) Representative: Grünecker Patent- und Rechtsanwälte PartG mbB
(86) International application number: PCT/JP2022/010972
(87) International publication number: WO 2022/244413

(57) **Abstract**

A solar cell 1000 according to the present disclosure includes a support 2, a photoelectric conversion element 1, and a sealing member 3. The photoelectric conversion element 1 is in a sealed space defined by the support 2 and the sealing member 3. The photoelectric conversion element 1 includes, in this order, a first electrode, a photoelectric conversion layer, and a second electrode. An oxygen concentration in the sealed space is less than 10 ppm in terms of volume fraction, and a water vapor concentration in the sealed space is greater than or equal to 100 ppm and less than or equal to 5000 ppm in terms of volume fraction.

## Description

The present disclosure relates to a solar cell and a method of producing a solar cell.

### Background Art

In recent years, a perovskite solar cell, which uses a perovskite crystal represented by a formula ABX₃ (where A represents a monovalent cation, B represents a divalent cation, and X represents a halogen anion) or a similar structure (hereinafter referred to as a "perovskite compound") as a photoelectric conversion material, has been under research and development. Various efforts are being made to improve photoelectric conversion efficiency and durability of the perovskite solar cell.

NPL 1 reports that atmospheric water vapor reacts with the perovskite compound and the reaction forms substances that do not contribute to power generation, such as lead iodide, methylammonium iodide, and hydrated compounds, on the surface or grain boundaries of the perovskite compound.

### Citation List

### Patent Literature

PTL 1: Japanese Unexamined Patent Application Publication No. 2017-103450 Non Patent Literature

NPL 1: Q. Sun and eight others, Advanced Energy Materials, July 2017, Vol. 7, p. 1700977
NPL 2: Taka.T., Synthetic Metals, January 1993, Vol. 57, p. 5014

### Summary of Invention

### Technical Problem

An object of the present disclosure is to improve durability of a solar cell.

### Solution to Problem

A solar cell according to the present disclosure includes:
a support;
a photoelectric conversion element; and
a sealing member, wherein
the photoelectric conversion element is in a sealed space defined by the support and the sealing member,
the photoelectric conversion element includes, in this order, a first electrode, a photoelectric conversion layer, and a second electrode,
an oxygen concentration in the sealed space is less than 10 ppm in terms of volume fraction, and
water vapor concentration in the sealed space is greater than or equal to 100 ppm and less than or equal to 5000 ppm in terms of volume fraction.

### Advantageous Effects of Invention

According to the present disclosure, a solar cell can have improved durability.

### Brief Description of Drawings

[Fig. 1] Fig. 1 illustrates a schematic configuration of a solar cell 1000 according to an embodiment of the present disclosure.
[Fig. 2] Fig. 2 is a cross-sectional view illustrating a schematic configuration of a first configuration example of a photoelectric conversion element 1 of the solar cell 1000 according to an embodiment of the present disclosure.
[Fig. 3] Fig. 3 is a cross-sectional view illustrating a schematic configuration of a second configuration example of the photoelectric conversion element 1 of the solar cell 1000 according to an embodiment of the present disclosure.
[Fig. 4] Fig. 4 is a cross-sectional view illustrating a schematic configuration of a third configuration example of the photoelectric conversion element 1 of the solar cell 1000 according to an embodiment of the present disclosure.
[Fig. 5] Fig. 5 is a graph showing the water vapor concentration dependence of the normalized photoelectric conversion efficiency of the solar cells of Examples 1, 4, and 6 and Comparative Example 1.
[Fig. 6] Fig. 6 is a graph showing the water vapor content dependence of the normalized photoelectric conversion efficiency of the solar cells of Examples 1, 4, and 6 and Comparative Example 1.
[Fig. 7] Fig. 7 is a graph showing the water vapor concentration dependence of the normalized photoelectric conversion efficiency of the solar cells of Examples 2, 3, 5, and 7 and Comparative Example 2.
[Fig. 8] Fig. 8 is a graph showing the water vapor content dependence of the normalized photoelectric conversion efficiency of the solar cells of Examples 2, 3, 5, and 7 and Comparative Example 2.

### Description of Embodiments

### <Underlying Knowledge Forming Basis of the Present Disclosure>

As reported in NPL 1, a perovskite compound containing lead reacts with water and forms substances that do not contribute to power generation, such as lead iodide, methylammonium iodide, and hydrated compounds, on the surface or grain boundaries of the perovskite compound. These reaction products are highly insulating. If the reaction products are produced in large amounts, movement of photogenerated carriers is inhibited. This degrades the properties of the perovskite solar cell. To avoid this problem, perovskite solar cells are generally used in a nitrogen atmosphere that has very little water in the surrounding area (e.g., a water vapor concentration of less than or equal to 0.1 ppm in terms of volume fraction). In this specification, all the water vapor concentrations and the oxygen concentrations described below are concentrations in terms of volume fraction.

PTL 1 discloses that a perovskite solar cell having a sealed structure has oxygen and moisture in the sealed space. It is disclosed that the heat resistance of the solar cell is improved by controlling the oxygen concentration in the space to greater than or equal to 5% and the moisture concentration (volume fraction) to less than or equal to 300 ppm. However, NPL 1 reports effects of oxygen on solar cells, in addition to the above-mentioned degradation of solar cell characteristics due to water vapor. Specifically, NPL 1 discloses that the normalized photoelectric conversion efficiency of a perovskite solar cell after a light exposure test decreases monotonically, as the oxygen concentration increases from 1% to 20%, with reference to when an oxygen concentration around the solar cell is 0%. As above, it is reported in NPL 1 that the light resistance decreases when the oxygen concentration is 5%. It seems to be difficult for solar cells to have both the thermal stability and the photostability when the oxygen concentration is greater than or equal to 5%.

NPL 2 discloses that the coordination of water to the vicinity of the main chain of a π-conjugated polymer, which is a hole transport material, improves the electrical conductivity of the polymer. However, no reports indicate that water vapor improved the thermal stability and the photostability, and the presence of water vapor has been considered a factor that decreases the durability.

As described above, regarding the photostability and the thermal stability, which are important in actual use, there has never been reported that the presence of water vapor contributes to improvement in the stability.

In view of these conventional technologies, the inventor conducted detailed research to find the threshold of water vapor concentration, i.e., the value of water vapor concentration at which the effect on the durability of solar cells becomes noticeable, with the oxygen concentration in the sealed space being kept below 2 ppm. The research revealed that the optimal water vapor concentration for the durability of solar cells exists between 0% and 1%. Specifically, in a solar cell having a sealed structure, the photoelectric conversion efficiency after a light exposure test and the photoelectric conversion efficiency after a light resistance test are improved when the water vapor concentration in the sealed space is greater than or equal to 100 ppm and less than or equal to 5000 ppm. It was also revealed that photoelectric conversion efficiency after a light exposure test and photoelectric conversion efficiency after a heat resistance test are further improved when the water vapor concentration in the sealed space is greater than or equal to 100 ppm and less than or equal to 1000 ppm. Thus, a solar cell can have both photostability and thermal stability when the water vapor concentration in the sealed space is in a range of greater than or equal to 100 ppm and less than or equal to 5000 ppm and can have higher photostability and higher thermal stability when the water vapor concentration in the sealed space is in a range of greater than or equal to 100 ppm and less than or equal to 1000 ppm.

### <Description of Embodiments>

A solar cell according to an embodiment of the present disclosure includes a support, a photoelectric conversion element, and a sealing member. The photoelectric conversion element is in the sealed space defined by the support and the sealing member. The photoelectric conversion element includes, in this order, a first electrode, a photoelectric conversion layer, and a second electrode. An oxygen concentration in the sealed space is less than 10 ppm, and a water vapor concentration in the sealed space is greater than or equal to 100 ppm and less than or equal to 5000 ppm.

The above-described configuration can reduce the photodegradation and the thermal degradation induced by defects in the photoelectric conversion material. Thus, the solar cell can have improved durability.

Furthermore, for example, the photoelectric conversion element may further include a hole transport layer. In such a case, because the water vapor concentration in the sealed space is in the above range, moisture is less likely to react with the photoelectric conversion material and the conductivity of the hole transport layer can be improved by moisture coordinated to the hole transport material. This can improve the conductivity of the solar cell. Thus, holes can be extracted efficiently, reducing the possibility that recombination will occur at the interface. Thus, for example, when the photoelectric conversion element further includes a hole transport layer, the above configuration can further improve the durability of the solar cell.

In the solar cell according to this embodiment, the water vapor concentration in the sealed space may be greater than or equal to 100 ppm and less than or equal to 1000 ppm.

The above configuration can further reduce the heat-induced structural change and the light-induced structural change of the photoelectric conversion material. Thus, the above-described configuration can further improve the photostability and the thermal stability of the solar cell.

In the solar cell according to this embodiment, the water vapor concentration in the sealed space may be greater than 300 ppm.

In the solar cell according to this embodiment, as described above, the oxygen concentration in the sealed space is less than 10 ppm. The solar cell can have higher light resistance when the sealed space has a low oxygen concentration of less than 10 ppm, and thus can have both the thermal stability and the photostability. The oxygen concentration in the sealed space may be less than or equal to 2 ppm to further improve the light resistance.

The water vapor concentration in the sealed space can be measured by an atmospheric pressure ionization mass spectrometer or gas chromatography, for example. In a specific example that uses an atmospheric pressure ionization mass spectrometer (API-TDS600, manufactured by NIPPON API CO., LTD.), a sample package (i.e., solar cell module) is broken in a destruction chamber under a purified argon gas atmosphere so that the gas components in the package (i.e., gas components in the sealed space) are detected, and the gas components in the package are quantitatively measured using a separately prepared calibration curve. In this way, the gas components in the sealed space can be measured. Although the sample package was broken in the destruction chamber as described above to collect the gas in the sealed space, the gas in the sealed space may be extracted with a syringe.

The oxygen concentration in the sealed space can be measured by an atmospheric pressure ionization mass spectrometer, gas chromatography, or an electrochemical oxygen sensor, for example. The gas in the sealed space may be collected by the same method as the above-described method of measuring water vapor concentration, for example.

Here, an example will be described in which the gas in the sealed space of a solar cell is allowed to escape to a closed space such as a destruction chamber, and the water vapor concentration and the oxygen concentration of the escaped gas are measured by using an atmospheric pressure ionization mass spectrometer. For example, a solar cell module is placed in a chamber filled with an inert gas, such as argon or krypton. The module is broken in the chamber to allow the gas in the sealed space of the solar cell to escape. Next, quantitative analysis is performed on the gas in the chamber by using an atmospheric pressure ionization mass spectrometer. All the components of the gas in the chamber are quantified, and the percentage of oxygen in the sum of the quantities is calculated to determine the oxygen concentration. Examples of gases in the sealed space, other than water vapor and oxygen, include an inert gas, such as nitrogen and noble gases, and carbon dioxide. If the sealed space contains the inert gas that is the same in type as the inert gas filling the chamber used for the gas analysis, accurate gas analysis may be difficult. To solve the problem, when the type of gas in the sealed space is unknown, two identical solar cell modules are provided, and the analysis of the gas is performed for each of the two solar cell modules by the above-described procedure using different types of inert gases as inert gases filling the chambers. The composition of the gas contained in the sealed space can be determined by comparison of the results of the two analyses.

The partial pressure of water vapor in the sealed space may be greater than or equal to 1 × 10⁻⁴ atm and 5 × 10⁻³ atm, or greater than or equal to 1 × 10⁻⁴ atm and 1 × 10⁻³ atm.

With the above-described configuration, the photodegradation and thermal degradation induced by defects in the photoelectric conversion material are more likely to be reduced. Thus, the solar cell can have improved durability.

When the solar cell according to the present disclosure is produced under atmospheric pressure, the pressure in the sealed space is about atmospheric pressure. In this case, the partial pressure of water vapor in the sealed space is greater than or equal to 1 × 10⁻⁴ atm and 1 × 10⁻³ atm.

To calculate the partial pressure of water vapor in the sealed space, the mass or molar concentration of the gas containing water vapor in the sealed space is determined by using the above-described method of measuring the water vapor concentration, and further the volume of the sealed space is measured. Then, the partial pressure is calculated by using an equation of state of a gas. For example, the volume of the sealed space can be estimated by injection of a liquid into the sealed space. Alternatively, the solar cell may be disassembled, and the shape of the space may be measured to estimate the volume. The above-described measurements are usually performed at room temperature, but the temperature is not limited to room temperature. In other words, the measurements may be performed at an actual operating temperature to enable the effects of adsorption and desorption of gases in the sealed space to be taken into consideration.

Modifications of the solar cell according to the embodiment of the present disclosure will be described. The same explanation can be omitted as appropriate.

As described above, the solar cell according to the present disclosure includes a support, a photoelectric conversion element, and a sealing member, and the photoelectric conversion element is in a sealed space defined by the support and the sealing member. The photoelectric conversion element includes, in this order, a first electrode, a photoelectric conversion layer, and a second electrode. The water vapor content in the sealed space per area of the surface of the photoelectric conversion element facing the sealed space may be greater than or equal to 2.3 × 10⁻⁶ mol/m² and less than or equal to 1.2 × 10⁻⁴ mol/m². In other words, a value obtained by dividing the water vapor content in the sealed space by the area of the surface of the photoelectric conversion element facing the sealed space may be greater than or equal to 2.3 × 10⁻⁶ mol/m² and less than or equal to 1.2 × 10⁻⁴ mol/m². This can reduce degradation due to long-term operation of the solar cell.

To further reduce the degradation due to long-term operation of the solar cell, the water vapor content in the sealed space per area of the surface of the photoelectric conversion element facing the sealed space may be greater than or equal to 2.3 × 10⁻⁶ mol/m² and less than or equal to 2.3 × 10⁻⁵ mol/m².

To reduce the degradation caused by oxygen, the amount of oxygen in the sealed space per area of the surface of the photoelectric conversion element facing the sealed space may be less than or equal to 7.0 × 10⁻⁵ mol/m². In other words, the value obtained by dividing the amount of oxygen in the sealed space by the area of the surface of the photoelectric conversion element facing the sealed space may be less than or equal to 7.0 × 10⁻⁵ mol/m².

In the photoelectric conversion element, the main surface of the first electrode may face the support, or the main surface of the second electrode may face the support.

The solar cell according to the present disclosure can be produced, for example, by the following method.

First, a photoelectric conversion element is produced by the method described below.

The produced photoelectric conversion element is sealed with a sealing member in a glove box having the controlled oxygen concentration.

The oxygen concentration in the glove box is less than 10 ppm in terms of volume fraction, and the water vapor concentration is greater than or equal to 100 ppm and less than or equal to 5000 ppm in terms of volume fraction. Alternatively, the water vapor content in the sealed space per area of the surface of the photoelectric conversion element facing the sealed space is adjusted to be greater than or equal to 2.3 × 10⁻⁶ mol/m² and less than or equal to 1.2 × 10⁻⁴ mol/m².

A solar cell having a predetermined oxygen concentration and a predetermined water vapor concentration can be produced by the above-described method.

As described above, a method of producing a solar cell may include performing sealing of a photoelectric conversion element that includes, in this order, a first electrode, a photoelectric conversion layer, and a second electrode in an atmosphere having an oxygen concentration of less than 10 ppm in terms of volume fraction and a water vapor concentration of greater than or equal to 100 ppm and less than or equal to 5000 ppm in terms of volume fraction to produce a solar cell.

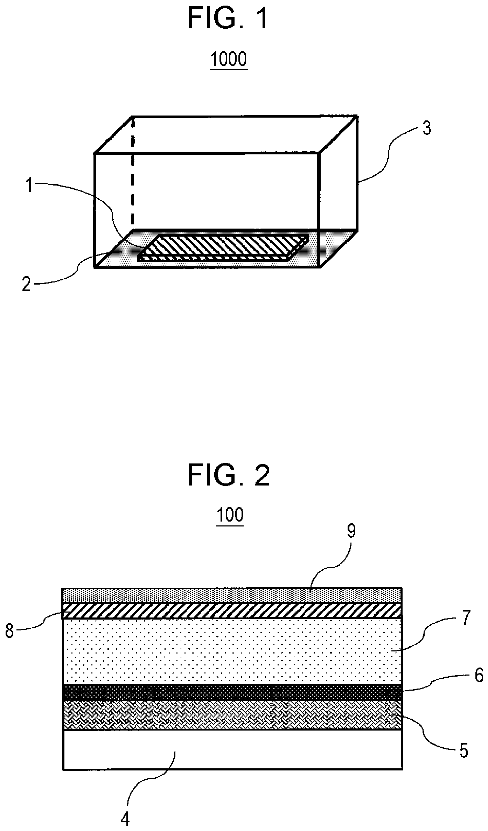

Fig. 1 is a view illustrating a schematic configuration of a solar cell 1000 according to the embodiment of the present disclosure.

The solar cell 1000 according to this embodiment includes a photoelectric conversion element 1, a support 2, and a sealing member 3. The photoelectric conversion element 1 is in the sealed space defined by the support 2 and the sealing member 3.

The photoelectric conversion element 1 may be in contact with the support 2.

The support 2 and the sealing member 3 may be formed of the same material. The material may have a gas barrier function, for example. The material may be glass.

Hereinafter, the photoelectric conversion element 1 is described in more detail with reference to first to third configuration examples. The photoelectric conversion elements in the first to third configuration examples below are non-limiting examples of the photoelectric conversion element 1.

Fig. 2 is a cross-sectional view illustrating a schematic configuration of a first configuration example of the photoelectric conversion element 1 of the solar cell 1000 according to the embodiment of the present disclosure.

The first configuration example of the photoelectric conversion element 100 includes, in this order, a substrate 4, a first electrode 5, an electron transport layer 6, a photoelectric conversion layer 7, a hole transport layer 8, and a second electrode 9. As the first configuration example of the photoelectric conversion element 100, the photoelectric conversion element 1 of the solar cell 1000 according to this embodiment may further include an electron transport layer between the first electrode and the photoelectric conversion layer and may further include a hole transport layer between the photoelectric conversion layer and the second electrode.

When the photoelectric conversion element 100 is irradiated with light, the photoelectric conversion layer 7 absorbs the light and generates excited electrons and holes. The excited electrons move through the electron transport layer 6 to the first electrode 5. The holes generated at the photoelectric conversion layer 7 move through the hole transport layer 8 to the second electrode 9. This allows current to be drawn from the photoelectric conversion element 100 through the first electrode 5, which serves as the negative electrode, and the second electrode 9, which serves as the positive electrode.

The photoelectric conversion element 100 may or may not include the substrate 4.

The photoelectric conversion element 100 may or may not include the electron transport layer 6. When the photoelectric conversion element 100 includes the electron transport layer 6, electrons can be efficiently moved to the first electrode 5. Thus, current can be efficiently drawn from the photoelectric conversion element 100.

The photoelectric conversion element 100 may or may not include the hole transport layer 8. When the photoelectric conversion element 100 includes the hole transport layer 8, holes can be efficiently moved to the second electrode 9. Thus, current can be efficiently drawn from the photoelectric conversion element 100.

The photoelectric conversion element 100 can be produced, for example, by the following method.

First, the first electrode 5 is formed on a surface of the substrate 4 by, for example, chemical vapor deposition or sputtering. Then, the electron transport layer 6 is formed by, for example, chemical vapor deposition, sputtering, or solution coating. Then, the photoelectric conversion layer 7 is formed on the electron transport layer 6. The photoelectric conversion layer 7 may be formed, for example, by solution coating, printing, or vapor deposition. Alternatively, for example, a perovskite compound cut into a predetermined thickness may be placed on the electron transport layer 6 and used as the photoelectric conversion layer 7. Then, the hole transport layer 8 is formed on the photoelectric conversion layer 7 by, for example, chemical vapor deposition, sputtering, or solution coating. Then, the second electrode 9 is formed on the hole transport layer 8 by, for example, chemical vapor deposition, sputtering, or solution coating. As above, the photoelectric conversion element 100 is produced.

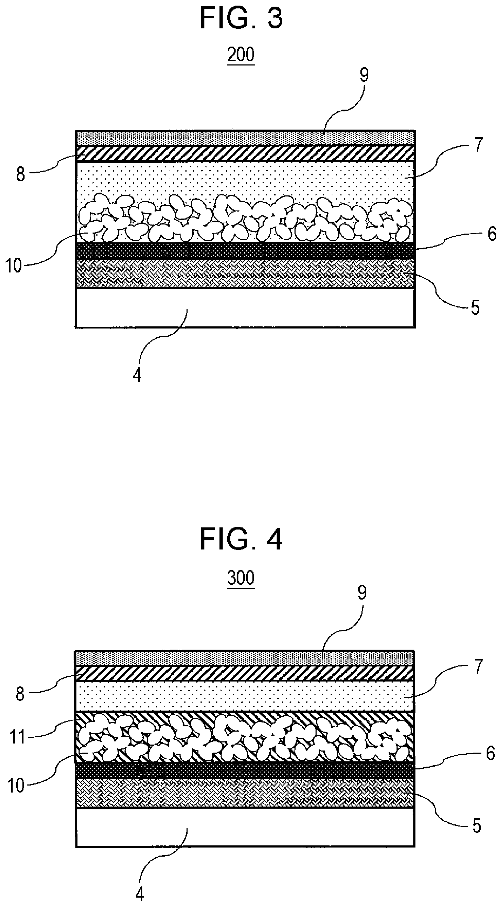

Fig. 3 is a cross-sectional view illustrating a schematic configuration of a second configuration example of the photoelectric conversion element 1 of the solar cell 1000 according to the embodiment of the present disclosure.

A photoelectric conversion element 200 of the second configuration example includes, in this order, the substrate 4, the first electrode 5, the electron transport layer 6, a porous layer 10, the photoelectric conversion layer 7, the hole transport layer 8, and the second electrode 9. As the photoelectric conversion element 200 of the second configuration example, the photoelectric conversion element 1 of the solar cell 1000 according to this embodiment may further include the porous layer. The porous layer is located, for example, between the electron transport layer and the photoelectric conversion layer.

The porous layer 10 contains a porous material. The porous material contains voids.

The photoelectric conversion element 200 may or may not include the substrate 4.

The photoelectric conversion element 200 may or may not include the electron transport layer 6. When the photoelectric conversion element 200 does not include the electron transport layer 6, the porous layer 10 is located between the first electrode 5 and the photoelectric conversion layer 7. When the photoelectric conversion element 200 includes the electron transport layer 6, electrons can be efficiently moved to the first electrode 5. Thus, current can be efficiently drawn from the photoelectric conversion element 200.

The photoelectric conversion element 200 may or may not include the hole transport layer 8. When the photoelectric conversion element 200 includes the hole transport layer 8, holes can be efficiently moved to the second electrode 9. Thus, current can be efficiently drawn from the photoelectric conversion element 200.

Fig. 4 is a cross-sectional view illustrating a schematic configuration of a third configuration example of the photoelectric conversion element 1 of the solar cell 1000 according to the embodiment of the present disclosure.

A photoelectric conversion element 300 of the third configuration example includes, in this order, the substrate 4, the first electrode 5, the electron transport layer 6, the porous layer 10, an intermediate layer 11, the photoelectric conversion layer 7, the hole transport layer 8, and the second electrode 9. As the photoelectric conversion element 300 of the third configuration example, the photoelectric conversion element 1 of the solar cell 1000 according to this embodiment may further include the intermediate layer. The intermediate layer is located, for example, between the porous layer and the photoelectric conversion layer.

The photoelectric conversion element 300 may or may not include the substrate 4.

The photoelectric conversion element 300 may or may not include the electron transport layer 6. When the photoelectric conversion element 300 includes the electron transport layer 6, electrons can be efficiently moved to the first electrode 5. Thus, current can be efficiently drawn from the photoelectric conversion element 300.

The photoelectric conversion element 300 may or may not include the hole transport layer 8. When the photoelectric conversion element 300 includes the hole transport layer 8, holes can be efficiently moved to the second electrode 9. Thus, current can be efficiently drawn from the photoelectric conversion element 300.

The photoelectric conversion element 300 may or may not include the porous layer 10. When the photoelectric conversion element 300 does not include the porous layer 10, the intermediate layer 11 is located between the electron transport layer 6 and the photoelectric conversion layer 7.

The components of the photoelectric conversion element will be described in detail below.

### (Substrate 4)

The substrate 4 is an optional component. The substrate 4 holds the layers of the photoelectric conversion element. The substrate 4 can be formed of a transparent material. For example, the substrate 4 may be a glass substrate or a plastic substrate. The plastic substrate may be, for example, a plastic film.

If the second electrode 9 has light-transmitting properties, the substrate 4 may be formed of a non-light-transmitting material. Examples of the material include metals, ceramics, and resin materials having low light-transmitting properties.

If the first electrode 5 has sufficient strength, the first electrode 5 can hold the layers, eliminating the need for the substrate 4.

### (First Electrode 5)

The first electrode 5 is conductive.

The first electrode 5 has light-transmitting properties. For example, the first electrode 5 transmits light in the visible to near-infrared range.

The first electrode 5 is composed of, for example, a transparent and conductive material. Examples of the material include metal oxides and metal nitrides. Examples of the materials include (i) titanium dioxide doped with at least one selected from the group consisting of lithium, magnesium, niobium, and fluorine; (ii) gallium oxide doped with at least one selected from the group consisting of tin and silicon; (iii) gallium nitride doped with at least one selected from the group consisting of silicon and oxygen, (iv) tin oxide doped with at least one selected from the group consisting of antimony and fluorine, (v) zinc oxide doped with at least one selected from the group consisting of boron, aluminum, gallium, and indium, (vi) indium-tin composite oxide, and (vii) a compound of the above materials.

The first electrode 5 may have a light-transmitting pattern. Examples of the light-transmitting pattern include a line pattern, a wave pattern, a lattice pattern, a perforated metal-like pattern having numerous fine through holes regularly or irregularly arranged. When the first electrode 5 has any of these patterns, light can pass through portions having no electrode material. Thus, the light-transmitting pattern makes non-transparent materials usable. Examples of the non-transparent electrode material include platinum, gold, silver, copper, aluminum, rhodium, indium, titanium, iron, nickel, tin, zinc, and alloys containing any of them. A conductive carbon material may be used as a non-transparent electrode material.

When the photoelectric conversion element does not include the electron transport layer 6, the first electrode 5 has blocking properties against holes from the photoelectric conversion layer 7. In such a case, the first electrode 5 is not in ohmic contact with the photoelectric conversion layer 7. Furthermore, the blocking properties against holes from the photoelectric conversion layer 7 are properties that only allow passage of electrons generated in the photoelectric conversion layer 7 and does not allow passage of holes. The Fermi energy of a material having such properties is higher than the energy level of the photoelectric conversion layer 7 at the upper end of the valence band. The Fermi energy of a material having such properties may be higher than the Fermi energy of the photoelectric conversion layer 7. A specific example of the material is aluminum.

When the photoelectric conversion element includes the electron transport layer 6, the first electrode 5 may have no blocking properties against holes from the photoelectric conversion layer 7. In this case, the first electrode 5 may be formed of a material that can form an ohmic contact with the photoelectric conversion layer 7. In this case, the first electrode 5 may or may not be in ohmic contact with the photoelectric conversion layer 7.

The light transmittance of the first electrode 5 may be, for example, greater than or equal to 50%, or greater than or equal to 80%. The wavelength of light to be transmitted through the first electrode 5 depends on the absorption wavelength of the photoelectric conversion layer 7.

The thickness of the first electrode 5 may be, for example, greater than or equal to 1 nm and less than or equal to 1000 nm.

### (Electron Transport Layer 6)

The electron transport layer 6 contains a semiconductor. The electron transport layer 6 may be formed of a semiconductor having a band gap of greater than or equal to 3.0 eV. This enables transmission of visible and infrared light to the photoelectric conversion layer 7. An example of the semiconductor is an inorganic n-type semiconductor.

Examples of the inorganic n-type semiconductor include metal oxide, metal nitride, and perovskite-type oxide. Examples of the metal oxide include oxides of Cd, Zn, In, Pb, Mo, W, Sb, Bi, Cu, Hg, Ti, Ag, Mn, Fe, V, Sn, Zr, Sr, Ga, Si, and Cr. The metal oxide is, for example, TiO₂ or SnO₂. The metal nitride is, for example, GaN. The perovskite-type oxide is, for example, SrTiO₃ or CaTiO₃.

The electron transport layer 6 may contain a material having a band gap of greater than 6.0 eV. Examples of such a material include (i) halides of alkali metals such as lithium fluoride and alkaline earth metals such as calcium fluoride, (ii) alkali metal oxides such as magnesium oxide, and (iii) silicon dioxide. In this case, the electron transport layer 6 may have a thickness of less than or equal to 10 nm, for example, to keep electron transport properties.

The electron transport layer 6 may include multiple layers formed of different materials.

### (Photoelectric Conversion Layer 7)

The photoelectric conversion layer 7 contains a photoelectric conversion material.

The photoelectric conversion material may be, for example, a perovskite compound. In other words, the photoelectric conversion layer 7 may contain a perovskite compound. The perovskite compound has a high optical absorption coefficient in the wavelength range of the solar spectrum and high carrier mobility. Thus, the photoelectric conversion element containing a perovskite compound has high photoelectric conversion efficiency.

The perovskite compound is represented, for example, by the formula ABX₃. A represent a monovalent cation. Examples of the monovalent cation include alkali metal cations and organic cations. Examples of the alkali metal cations include a potassium cation (K⁺), a cesium cation (Cs⁺), and a rubidium cation (Rb⁺). Examples of organic cations include a methylammonium cation (MA⁺ or CH₃NH₃⁺), a formamidinium cation (FA⁺ or HC(NH₂)₂⁺), an ethylammonium cation (CH₃CH₂NH₃⁺), and a guanidinium cation (CH₆N₃⁺). B represents a divalent cation. Examples of the divalent cation include a lead cation (Pb₂⁺) and a tin cation (Sn₂⁺). X represents a monovalent anion. Examples of the monovalent anion include a halogen anion. Each of the A, B, and X sites may be occupied by two or more types of ions.

The photoelectric conversion material may be, for example, a lead-containing perovskite compound.

The thickness of the photoelectric conversion layer 7 is, for example, greater than or equal to 50 nm and less than or equal to 10 µm.

The photoelectric conversion layer 7 is formed, for example, by solution coating, printing, or vapor deposition. A perovskite compound may be cut out and placed to form the photoelectric conversion layer 7.

The photoelectric conversion layer 7 may contain a perovskite compound represented by the formula ABX₃ as a main component. Here, "the photoelectric conversion layer 7 contains a perovskite compound represented by the formula ABX₃ as a main component" means that the photoelectric conversion layer 7 contains greater than or equal to 90% by mass perovskite compound represented by the formula ABX₃. The photoelectric conversion layer 7 may contain greater than or equal to 95% by mass perovskite compound represented by the formula ABX₃. The photoelectric conversion layer 7 may be composed of a perovskite compound represented by the formula ABX₃. The photoelectric conversion layer 7 only needs to contain a perovskite compound represented by the formula ABX₃ and may have defects or impurities.

The photoelectric conversion layer 7 may further contain a different compound from the perovskite compound represented by the formula ABX₃. Examples of the other compounds include a compound having a Ruddlesden-Popper type layered perovskite structure.

### (Hole Transport Layer 8)

The hole transport layer 8 contains a hole transport material. The hole transport material transports holes. The hole transport material is, for example, an organic or inorganic semiconductor.

The hole transport layer 8 may contain an organic semiconductor. The organic semiconductor forms a good interface with the photoelectric conversion layer 7 and can reduce the formation of interface defects during bonding. This enables the photoelectric conversion element to have high photoelectric conversion efficiency and high durability.

Examples of the organic semiconductor include triphenylamine, triallylamine, phenylbenzidine, phenylenevinylene, tetrathiafulvalene, vinylnaphthalene, vinylcarbazole, thiophene, aniline, pyrrole, carbazole, triptycene, fluorene, azulene, pyrene, pentacene, perylene, acridine, and phthalocyanine.

Typical examples of the organic semiconductor used as the hole transport material include 2,2',7,7'-tetrakis-(N,N-di-p-methoxyphenylamine)9,9'-spirobifluorene, poly[bis(4-phenyl)(2,4,6-trimethylphenyl)amine] (hereinafter, may be referred to as "PTAA"), poly(3-hexylthiophene-2,5-diyl), poly(3,4-ethylenedioxythiophene), and copper phthalocyanine. These organic semiconductors have high hole transport properties. Thus, the photoelectric conversion efficiency of the photoelectric conversion element can be improved.

The organic semiconductor may contain at least one selected from the group consisting of 2,2',7,7'-tetrakis-(N,N-di-p-methoxyphenylamine)9,9'-spirobifluorene and poly[bis(4-phenyl)(2,4,6-trimethylphenyl)amine].

The inorganic semiconductor used as the hole transport material is a p-type semiconductor. Examples of the inorganic semiconductor include Cu₂O, CuGaO₂, CuSCN, CuI, NiOₓ, MoOₓ, V₂O₅, and carbon materials such as a graphene oxide. Here, x > 0 is satisfied.

The hole transport layer 8 may include multiple layers formed of different materials. For example, the layers may be laminated such that the ionization potential of the hole transport layer 8 gradually decreases relative to the ionization potential of the photoelectric conversion layer 7. This improves the hole transport properties.

The thickness of the hole transport layer 8 may be greater than or equal to 1 nm and less than or equal to 1000 nm, or greater than or equal to 10 nm and less than or equal to 50 nm. This can provide sufficient hole transport properties. Thus, the solar cell can keep the low resistance and thus can have high photoelectric conversion efficiency.

The hole transport layer 8 is formed, for example, by coating, printing, or vapor deposition. This is the same as the photoelectric conversion layer 7. Examples of the coating include a doctor blade method, a bar coating method, a spray method, a dip coating method, and a spin coating method. An example of the printing is a screen-printing method. The hole transport layer 8 may be formed of a mixture of multiple materials and may be pressurized or heat-treated, as necessary. If the hole transport layer 8 is formed of an organic low-molecular weight material or inorganic semiconductor, the hole transport layer 8 can also be produced by vacuum deposition.

The hole transport layer 8 may contain an additive in addition to the hole transport material to improve the conductivity. Examples of the additive include a supporting electrolyte, a solvent, and a dopant. The supporting electrolyte and the solvent stabilize the holes in the hole transport layer 8. The dopant increases the number of holes in the hole transport layer 8.

Examples of the supporting electrolyte include an ammonium salt, an alkaline earth metal salt, and a transition metal salt. Examples of the ammonium salt include tetrabutylammonium perchlorate, tetraethylammonium hexafluorophosphate, an imidazolium salt, and a pyridinium salt. Examples of the alkali metal salt include lithium perchlorate and potassium boron tetrafluoride. An example of the alkaline earth metal salt is bis(trifluoromethanesulfonyl)imide calcium(II). Examples of the transition metal salt include bis(trifluoromethanesulfonyl)imide zinc(II) and tris[4-tert-butyl-2-(1H-pyrazol-1-yl)pyridine] cobalt(III) tris(trifluoromethanesulfonyl)imide.

An example of the dopant is a fluorinated aromatic boron compound. An example of the fluorinated aromatic boron compound is tris(pentafluorophenyl)borane.

The solvent in the hole transport layer 8 may have high ionic conductivity. The solvent may be an aqueous solvent or an organic solvent. To make the solute more stable, the solvent in the hole transport layer 8 may be an organic solvent. Examples of the organic solvent include a heterocyclic compound solvent such as tert-butylpyridine, pyridine, and n-methylpyrrolidone.

The solvent may be an ionic liquid. The ionic liquid may be used alone or in combination with another solvent. The ionic liquid is preferable because of its low volatility and high flame resistance.

Examples of the ionic liquid include imidazolium-based ionic liquids such as 1-ethyl-3-methylimidazolium tetracyanoborate, pyridine-based ionic liquids, alicyclic amine-based ionic liquids, aliphatic amine-based ionic liquids, and azonium amine-based ionic liquids.

The hole transport layer 8 may contain, as an additive, at least one selected from the group consisting of tert-butylpyridine, bis(trifluoromethanesulfonyl)imide calcium(II), bis(trifluoromethanesulfonyl)imide zinc(II), tris[4-tert-butyl-2-(1H-pyrazol-1-yl)pyridine] cobalt(III) tris(trifluoromethanesulfonyl)imide, and tris(pentafluorophenyl)borane. This improves the hole transport properties of the hole transport layer 8. Thus, the photoelectric conversion efficiency of the photoelectric conversion element can be improved.

### (Second Electrode 9)

The second electrode 9 is conductive.

When the photoelectric conversion element does not include the hole transport layer 8, the second electrode 9 has blocking properties against electrons from the photoelectric conversion layer 7. In this case, the second electrode 9 is not in ohmic contact with the photoelectric conversion layer 7. The blocking properties against electrons from the photoelectric conversion layer 7 are properties that only allow passage of holes generated at the photoelectric conversion layer 7 and does not allow passage of electrons. The Fermi energy of a material having such properties may be lower than the energy level of the photoelectric conversion layer 7 at the lower end of the valence band. The Fermi energy of a material having such properties may be lower than the Fermi energy of the photoelectric conversion layer 7. Specific examples of the material include platinum, gold, and a carbon material such as graphene.

When the photoelectric conversion element includes the hole transport layer 8, the second electrode 9 may have no blocking properties against holes from the photoelectric conversion layer 7. In this case, the second electrode 9 may be formed of a material that can form an ohmic contact with the photoelectric conversion layer 7. This allows the second electrode 9 to have light-transmitting properties.

Of the first electrode 5 and the second electrode 9, only at least one electrode that is located on a light-receiving side needs to have light-transmitting properties. Thus, one of the first electrode 5 and the second electrode 9 may have no light-transmitting properties. In other words, one of the first electrode 5 and the second electrode 9 does not need to contain a light-transmitting material and does not need to have a pattern having light-transmitting openings.

### (Porous Layer 10)

The porous layer 10 is formed on the electron transport layer 6 by, for example, coating. If the photoelectric conversion element does not include the electron transport layer 6, the porous layer 10 is formed on the first electrode 5.

The pore structure given by the porous layer 10 serves as the foundation for formation of the photoelectric conversion layer 7. The porous layer 10 does not inhibit light absorption of the photoelectric conversion layer 7 and electron transfer from the photoelectric conversion layer 7 to the electron transport layer 6.

The porous layer 10 contains a porous material.

The porous material is formed, for example, of a series of insulating or semiconducting particles. Examples of the insulating particles include an aluminum oxide particle and a silicon oxide particle. An example of the semiconductor particles is an inorganic semiconductor particle. Examples of the inorganic semiconductor include metal oxides, perovskite oxides of metal elements, sulfides of metal elements, and metal chalcogenides. Examples of the metal oxide include oxides of Cd, Zn, In, Pb, Mo, W, Sb, Bi, Cu, Hg, Ti, Ag, Mn, Fe, V, Sn, Zr, Sr, Ga, Si, and Cr. An example of the metal oxide is TiO₂. Examples of the perovskite oxide of a metal element include SrTiO₃ and CaTiO₃. Examples of the sulfide of a metal element include CdS, ZnS, In₂S₃, PbS, Mo₂S, WS₂, Sb₂S₃, Bi₂S₃, ZnCdS₂, and Cu₂S. Examples of the metal chalcogenide include CsSe, In₂Se₃, WSe₂, HgS, PbSe, and CdTe.

The thickness of the porous layer 10 may be greater than or equal to 0.01 µm and less than or equal to 10 µm, or greater than or equal to 0.05 µm and less than or equal to 1 µm.

For the surface roughness of the porous layer 10, the surface roughness coefficient given by the effective area/the projected area may be greater than or equal to 10, or greater than or equal to 100. The projected area is the area of shadow created behind an object that is illuminated by light directly from the front. The effective area is the actual surface area of the object. The effective area can be calculated from the volume, which is calculated from the projected area and the thickness of the object, and the specific surface area and bulk density of the material constituting the object. The specific surface area is measured, for example, by nitrogen adsorption.

The voids in the porous layer 10 extend continuously through the porous layer 10 from one main surface to the other main surface. In other words, the voids in the porous layer 10 extend continuously from the main surface of the porous layer 10 in contact with the photoelectric conversion layer 7 to the main surface of the porous layer 10 in contact with the electron transport layer 6. This enables the material of the photoelectric conversion layer 7 to fill the voids in the porous layer 10 to the electron transport layer 6. Thus, the presence of the porous layer 10 does not prevent transport of electrons, because the photoelectric conversion layer 7 is in direct contact with the electron transport layer 6.

The presence of the porous layer 10 makes the formation of the photoelectric conversion layer 7 easy. Since the porous layer 10 is present, the material of the photoelectric conversion layer 7 enters the voids of the porous layer 10, allowing the porous layer 10 to serve as a foothold for the photoelectric conversion layer 7. This reduces the possibility that the material of the photoelectric conversion layer 7 will be repelled by or agglomerated on the surface of the porous layer 10. Thus, the photoelectric conversion layer 7 can be readily formed as a uniform film. The photoelectric conversion layer 7 can be formed by the above coating, printing, or vapor deposition.

Light scattering caused by the porous layer 10 is also expected to elongate the optical path length of light passing through the photoelectric conversion layer 7. The increase in the optical path length will increase the number of electrons and holes generated in the photoelectric conversion layer 7.

### (Intermediate Layer 11)

The intermediate layer 11 includes a self-assembled monolayer having fullerene (C₆₀), a C₆₀ derivative, or C₆₀ (also referred to as "C60SAM"). The intermediate layer 11 efficiently collects electrons, reducing the resistance loss in transporting electrons to the electron transport layer 6.

Examples of C₆₀ derivatives include [6,6]-Phenyl C₆₁ butyricacid methyl ester and [6,6]-Phenyl-C₆₁ butyric acid butyl ester. Examples of C60SAM include 4-(1',5'-Dihydro-1'-methyl-2'H-[5,6]fullereno-C₆₀-Ih-[1,9-c]pyrrol-2'-yl)benzoic acid, (1,2-methanofullerene C₆₀)-61-carboxylic acid, and C₆₀ Pyrrolidine tris-acid.

The intermediate layer 11 is formed, for example, by solution coating, dipping, printing, or vapor deposition.

### EXAMPLES

Hereafter, the present disclosure will be described in more detail with reference to examples and comparative examples.

In examples and comparative examples, perovskite solar cells were produced, and the solar cells were evaluated in terms of initial characteristics, characteristics after a light resistance test, and characteristics after a heat resistance test.

Components of the photoelectric conversion element of the solar cell of Examples 1, 4, and 6 and Comparative Example 1 are as follows:
Substrate: a glass substrate (thickness: 0.7 mm);
First electrode: a transparent electrode (indium-tin composite oxide layer) (thickness: 100 nm);
Electron transport layer: titanium dioxide (TiO₂) (thickness: 30 nm);
Porous layer: a mixed layer of a mesoporous titanium dioxide (TiO₂) (thickness: 150 nm) and a material of a photoelectric conversion layer below;
Photoelectric conversion layer: layer containing HC(NH₂)₂PbI₃ as a main component (thickness: 500 nm);
Hole transport layer: a layer containing phenethylammonium iodide (manufactured by GreatCell Solar Limited) and a layer containing PTAA as a main component (and lithium bis(trifluoromethanesulfonyl)imide (manufactured by Sigma-Aldrich Co. LLC) and 4-tert-butylpyridine) as additives (thickness: 50 nm)); and
Second electrode: Au (thickness: 200 nm).

Components of the photoelectric conversion element of the solar cell of Examples 2, 3, 5, and 7 and Comparative Example 2 are as follows:
Substrate: a glass substrate (thickness: 0.7 mm);
First electrode: a transparent electrode (indium-tin composite oxide layer) (thickness: 100 nm);
Electron transport layer: titanium dioxide (TiO₂) (thickness: 30 nm) Porous layer: a mesoporous titanium dioxide (TiO₂);
Intermediate layer: 4-(1',5'-Dihydro-1'-methyl-2'H-[5,6]fullereno-C₆₀-Ih-[1,9-c]pyrrol-2'-yl)benzoic acid (or C60SAM) (manufactured by Sigma-Aldrich Co. LLC)
(thickness: 50 nm (thickness including mesoporous titanium dioxide)), and including a material of the photoelectric conversion layer in the voids);
Photoelectric conversion layer: layer containing HC(NH₂)₂PbI₃ as a main component (thickness: 500 nm);
Hole transport layer: layer containing n-butylammonium bromide (manufactured by GreatCell Solar Limited)/a layer containing PTAA as a main component (and tris(pentafluorophenyl)borane (manufactured by Tokyo Chemical Industry Co., Ltd.) as an additive); and
Second electrode: Au (thickness: 200 nm).

As described above, the photoelectric conversion elements of the solar cells according to Examples 1, 4, and 6, and Comparative Example 1 were each the photoelectric conversion element of the second configuration example illustrated in Fig. 3. Furthermore, the photoelectric conversion elements of the solar cells according to Examples 2, 3, 5, and 7 and Comparative Example 2 were the photoelectric conversion elements of the third configuration example illustrated in Fig. 4.

### <Production of Photoelectric Conversion Element>

### (Example 1)

First, a glass substrate having a thickness of 0.7 mm was provided. The substrate serves as a support of the solar cell of the present disclosure.

An indium-tin composite oxide layer was formed on the substrate by sputtering. In this way, a first electrode was formed.

Next, a titanium dioxide layer was formed on the first electrode by sputtering. In this way, an electron transport layer was formed.

The electron transport layer was coated with 30NR-D (manufactured by GreatCell Solar Limited) by spin coating and then heat-treated at 500°C for 30 minutes to form a titanium dioxide layer having a mesoporous structure. In this way, a porous layer was formed.

Next, the substrate on which the first electrode, the electron transport layer, and the porous layer were formed was immersed in the C60SAM solution for 30 minutes and then taken out. Here, the C60SAM solution was produced by adding C60SAM into a mixture containing tetrahydrofuran (manufactured by FUJIFILM Wako Pure Chemical Corporation) and ethanol (manufactured by FUJIFILM Wako Pure Chemical Corporation) in a 1:1 volume ratio so that its concentration becomes 1 × 10⁻⁵ mol/L. The substrate that was taken out was rinsed thoroughly with an ethanol solution and then annealed on a hot plate at 100°C for 30 minutes. After annealing, the substrate was allowed to cool naturally to room temperature, and thus a C60SAM-modified substrate was produced. In this way, the intermediate layer was formed.

Next, a raw material solution of a photoelectric conversion material was applied by spin coating to form a photoelectric conversion layer containing a perovskite compound. The raw material solution contains 0.92 mol/L of lead(II) iodide (manufactured by Tokyo Chemical Industry Co., Ltd.), 0.17 mol/L of lead(II) bromide (manufactured by Tokyo Chemical Industry Co., Ltd.), 0.83 mol/L of formamidinium iodide (manufactured by GreatCell Solar Limited), 0.17 mol/L of methylammonium bromide (manufactured by GreatCell Solar Limited), 0.05 mol/L of cesium iodide (manufactured by Iwatani Corporation), and 0.05 mol/L of rubidium iodide (manufactured by Iwatani Corporation). The solvent of the solution was a mixture of dimethyl sulfoxide (manufactured by Acros) and N,N-dimethylformamide (manufactured by Acros). The mixing ratio (DMSO:DMF) of dimethyl sulfoxide (DMSO) and N,N-dimethylformamide (DMF) in this raw material solution was 1:4 by volume.

Next, a hole transport layer was formed on the photoelectric conversion layer. An isopropyl alcohol (manufactured by Acros Organics) solution containing 1 g/L phenethylammonium iodide (manufactured by GreatCell Solar Limited) was provided and spin-coated on the photoelectric conversion layer. In this way, a layer containing phenethylammonium iodide was formed. Then, a solution containing PTAA was applied by spin coating to form a layer containing mainly PTAA. The solvent for the solution containing PTAA was toluene (manufactured by Acros). The solution containing PTAA contained 10 g/L of PTAA, lithium bis(trifluoromethanesulfonyl)imide, and 4-tert butylpyridine.

Next, an Au film was deposited on the hole transport layer by vacuum evaporation to form the second electrode 9. As above, the photoelectric conversion element was produced on the glass substrate, which is the support.

Next, sealing of the photoelectric conversion element of Example 1 was performed in a glove box in which the water vapor concentration was adjusted to 100 ppm. Here, the oxygen concentration in the glove box was less than or equal to 2 ppm. The photoelectric conversion element of Example 1 was sealed with a UV-curing resin, a cover glass, and the glass substrate. In other words, the photoelectric conversion element including the first electrode, the electron transport layer, the porous layer, the photoelectric conversion layer, the hole transport layer, and the second electrode was sealed with the UV-curing resin, the cover glass, and the glass substrate. In this way, the solar cell according to Example 1 was produced. In the photoelectric conversion element of Example 1, the water vapor concentration in the sealed space was 100 ppm and the oxygen concentration was less than or equal to 2 ppm.

### (Example 2)

A solar cell was produced in the same way as in Example 1, except that the intermediate layer was formed and materials different from those used in Example 1 were used to produce the hole transport layer. A procedure for forming the intermediate layer and the materials of the hole transport layer will be described.

The intermediate layer was formed by the following procedure. The substrate on which the first electrode, the electron transport layer, and the porous layer were formed by the same method as in Example 1 was immersed in the C60SAM solution for 30 minutes and then taken out. Here, the C60SAM solution was produced by adding C60SAM into a mixture containing tetrahydrofuran (manufactured by FUJIFILM Wako Pure Chemical Corporation) and ethanol (manufactured by FUJIFILM Wako Pure Chemical Corporation) in a 1:1 volume ratio so that its concentration becomes 1 × 10⁻⁵ mol/L. The substrate that was taken out was rinsed thoroughly with an ethanol solution and then annealed on a hot plate at 100°C for 30 minutes. After annealing, the substrate was allowed to cool naturally to room temperature, and a C60SAM-modified substrate was produced. In this way, the intermediate layer was formed.

A solution for forming the layer containing n-butylammonium bromide of the hole transport layer was the same as the solution containing phenethylammonium iodide used in Example 1 except that n-butylammonium bromide (manufactured by GreatCell Solar Limited) was contained instead of phenethylammonium iodide. A solution for forming the layer containing mainly PTAA was the same as the solution containing PTAA used in Example 1, except that tris(pentafluorophenyl)borane was contained instead of lithium bis(trifluoromethanesulfonyl)imide and 4-tert butylpyridine. The hole transport layer was formed in the same way as in Example 1 except for the above.

In this way, the solar cell according to Example 2 was produced.

### (Example 3)

In Example 3, sealing of the photoelectric conversion element was performed in a glove box in which the water vapor concentration was adjusted to 500 ppm. The solar cell according to Example 3 was produced in the same way as in Example 2 except for this.

### (Example 4)

In Example 4, sealing of the photoelectric conversion element was performed in a glove box in which the water vapor concentration was adjusted to 1000 ppm. The solar cell according to Example 4 was produced in the same way as in Example 1 except for this.

### (Example 5)

In Example 5, sealing of the photoelectric conversion element was performed in a glove box in which the water vapor concentration was adjusted to 1000 ppm. The solar cell according to Example 5 was produced in the same way as in Example 2 except for this.

### (Example 6)

In Example 6, sealing of the photoelectric conversion element was performed in a glove box in which the water vapor concentration was adjusted to 5000 ppm. The solar cell according to Example 6 was produced in the same way as in Example 1 except for this.

### (Example 7)

In Example 7, sealing of the photoelectric conversion element was performed in a glove box in which the water vapor concentration was adjusted to 5000 ppm. The solar cell according to Example 7 was produced in the same way as in Example 2 except for this.

### (Comparative Example 1)

In Comparative Example 1, sealing of the photoelectric conversion element was performed in a glove box in which the water vapor concentration was adjusted to 10 ppm. The solar cell according to Comparative Example 1 was produced in the same way as in Example 1 except for this.

### (Comparative Example 2)

In Comparative Example 2, sealing of the photoelectric conversion element was performed in a glove box in which the water vapor concentration was adjusted to 10 ppm. The solar cell according to Comparative Example 2 was produced in the same way as in Example 2 except for the above.

### <Measurement of Photoelectric Conversion Efficiency>

The photoelectric conversion efficiency of the solar cells according to Examples 1 to 7 and Comparative Examples 1 and 2 were measured.

The photoelectric conversion efficiency of the solar cells were measured using an electrochemical analyzer (ALS440B, manufactured by BAS) and a xenon light source (BPS X300BA, manufactured by Bunkoukeiki Co., Ltd.) for the initial state, after the light resistance test, and after the heat resistance test. Before the measurement, the light intensity was calibrated to 1 Sun (100 mW/cm²) by using a silicon photodiode. The voltage sweep rate was set to 100 mV/s and the current-voltage characteristic was measured. No preconditioning, such as light irradiation and prolonged forward bias application, was performed prior to the start of the measurement. To fix the effective area and reduce the influence of scattered light, the solar cell was masked with a black mask having an aperture of 0.1 cm² and irradiated with light from the mask/glass substrate side. The output at the current-voltage condition that maximizes the power was defined as the photovoltaic conversion efficiency. The photoelectric conversion efficiency was measured at room temperature and under dry air (<2% RH).

### <Light Resistance Test>

A light resistance test was conducted on the solar cells according to Examples 1 to 7 and Comparative Examples 1 and 2. In the light resistance test, the voltage and the current of the solar cells were kept near the operating point that maximizes the output, and the output values were measured. Light equivalent to 1 Sun was applied from the substrate side for 90 hours with the temperature of the substrate being kept at 50°C. After the light resistance test, the photoelectric conversion efficiency of the solar cells were measured using the method described above.

### <Heat Resistance Test>

A heat resistance test was conducted on the solar cells of Examples 1 to 7 and Comparative Examples 1 and 2. The solar cells were kept in a thermostatic chamber at 85°C for 190 hours. After the heat resistance test, the photoelectric conversion efficiency of the solar cells was measured using the method described above.

Table 1 indicates the results of the above experiments, i.e., the measurement results of the photoelectric conversion efficiency of the solar cells for the initial state, after the light resistance test, and after the heat resistance test. In the table, for the additives contained in the raw material solution for the hole transport layer, lithium bis(trifluoromethanesulfonyl)imide is shown as "LiTFSI", and tris(pentafluorophenyl) is shown as "TPFPB". In order to evaluate the differences in efficiency depending on the water vapor concentration for each additive, Table 1 indicates the decrease rates in efficiency in which the maximum efficiencies of the additives were used as the reference. In the table, the decrease rate in efficiency for each additive with reference to the maximum efficiency are shown as "decrease rate in conversion efficiency."

**[Table 1]**

| | Water vapor concentration (ppm) | Water vapor content (mol/m²) | Additive | Photoelectric conversion efficiency (%) | | | Decrease rate in conversion efficiency (%) | |
|---|---|---|---|---|---|---|---|---|
| | | | | Initial stage | After light resistance test | After heat resistance test | After light resistance test | After heat resistance test |
| Com. Ex. 1 | 10 | 2.3×10⁻⁷ | LiTFSI | 19.6 | 5.7 | 18.6 | -52 | -5.8 |
| Com. Ex. 2 | 10 | 2.3×10⁻⁷ | TPFPB | 19.9 | 18.7 | 13.0 | -2.4 | -23 |
| Ex. 1 | 100 | 2.3×10⁻⁶ | LiTFSI | 19.9 | 11.9 | 19.7 | -0.3 | 0 |
| Ex. 2 | 100 | 2.3×10⁻⁶ | TPFPB | 20.0 | 18.2 | 14.4 | -5.0 | -15 |
| Ex. 3 | 500 | 1.2×10⁻⁵ | TPFPB | 19.9 | 18.4 | 15.6 | -3.9 | -7.8 |
| Ex. 4 | 1000 | 2.3×10⁻⁵ | LiTFSI | 19.3 | 11.9 | - | 0 | - |
| Ex. 5 | 1000 | 2.3×10⁻⁵ | TPFPB | 19.9 | 19.2 | - | 0 | - |
| Ex. 6 | 5000 | 1.2×10⁻⁴ | LiTFSI | 19.3 | 10.9 | 19.4 | -8.2 | -1.5 |
| Ex. 7 | 5000 | 1.2×10⁻⁴ | TPFPB | 19.8 | 14.6 | 16.9 | -24 | 0 |

Regarding the efficiency after the light resistance test and after the heat resistance test for each additive, in order to compare the effect of water vapor concentration on the durability, the normalized photoelectric conversion efficiency was determined with reference to the photoelectric conversion efficiency at the water vapor concentration that showed the maximum efficiency after the tests.

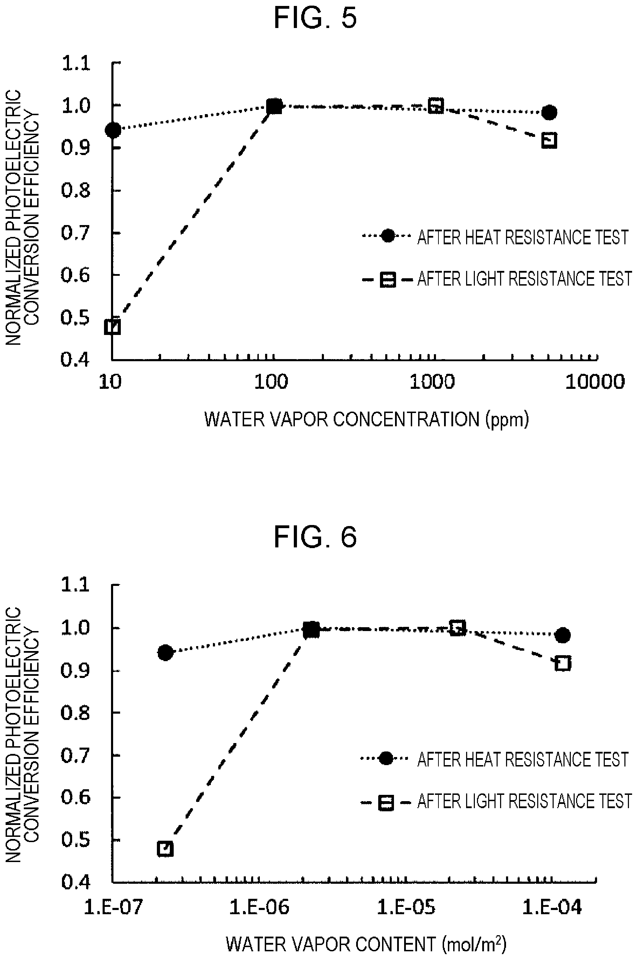

Fig. 5 is a graph showing the water vapor concentration dependence of the normalized photoelectric conversion efficiency of the solar cells of Examples 1, 4, and 6 and Comparative Example 1. In other words, Fig. 5 is a graph indicating the water vapor concentration dependence of the normalized photoelectric conversion efficiency in a case in which the additive in the hole transport layer is LiTFSI.

Fig. 6 is a graph showing the water vapor content dependence of the normalized photoelectric conversion efficiency of the solar cells of Examples 1, 4, and 6 and Comparative Example 1. In other words, Fig. 6 indicates the water vapor content dependence of the normalized photoelectric conversion efficiency in a case in which the additive in the hole transport layer is LiTFSI. Fig. 6 is a graph in which the water vapor concentrations in the sealed space indicated by the horizontal axis of Fig. 5 are converted to the values obtained by dividing the water vapor content by the area of the surface of the photoelectric conversion element facing the sealed space.

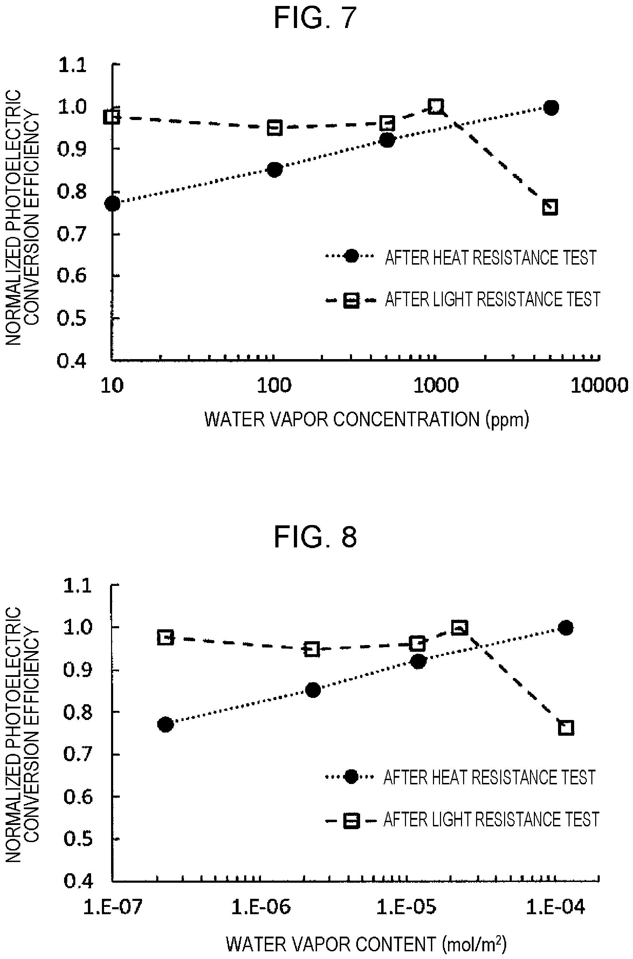

Fig. 7 is a graph showing the water vapor concentration dependence of the normalized photoelectric conversion efficiency of the solar cells of Examples 2, 3, 5, and 7 and Comparative Example 2. In other words, Fig. 7 indicates the water vapor concentration dependence of the normalized photoelectric conversion efficiency in a case in which the additive in the hole transport layer is TPFPB.

Fig. 8 is a graph showing the water vapor content dependence of the normalized photoelectric conversion efficiency of the solar cells of Examples 2, 3, 5, and 7 and Comparative Example 2. In other words, Fig. 8 indicates the water vapor content dependence of the normalized photoelectric conversion efficiency in a case in which the additive in the hole transport layer is LiTFSI. Fig. 8 is a graph in which the water vapor concentrations in the sealed space indicated by the horizontal axis of Fig. 7 are converted to the values obtained by dividing the water vapor content by the area of the surface of the photoelectric conversion element facing the sealed space.

In Examples and Comparative Examples, the volume of the sealed space of the solar cell was about 1.4 × 10⁻⁷ m³, and the area of the surface of the photoelectric conversion element facing the sealed space was 2.6 × 10⁻⁴ m².

### <Effect of Water Vapor Concentration on Initial Solar Cell Characteristics>

As indicated in Table 1, there is no significant difference in the initial photoelectric conversion efficiency when the water vapor concentrations in the sealed space are less than or equal to 5000 ppm. The initial photoelectric conversion efficiency was stable without light irradiation and heating.

### <Effect of Water Vapor Concentration on Solar Cell Characteristics After Light Resistance Test>

As indicated in Table 1 and Figs. 5 and 7, when the water vapor concentration in the sealed space is greater than or equal to 100 ppm and less than or equal to 5000 ppm, the photoelectric conversion efficiency after the light resistance test is high. In contrast, when the water vapor concentration is 10 ppm, which is in the low water vapor concentration region, and the additive is lithium bis(trifluoromethanesulfonyl) imide (LiTFSI), the decrease in photoelectric conversion efficiency is large. From the graph in Fig. 5, it can be predicted that, when the water vapor concentration is greater than 5000 ppm, the photoelectric conversion efficiency decreases more from the photoelectric conversion efficiency at the water vapor concentration of 5000 ppm. When the water vapor concentration is greater than 5000 ppm, the degradation phenomenon induced by the excess moisture may generate a large amount of decomposition products of perovskite compound (e.g., metal iodides) on the surface and/or grain boundaries of the perovskite compound. This may inhibit the movement of carriers. On the other hand, when the water vapor concentration is less than or equal to 5000 ppm, the above decomposition products contribute to defect passivation in the perovskite compound, which suppresses the photodegradation phenomenon induced by defects in the photoelectric conversion material. This seems to have reduced the deterioration of the photoelectric conversion efficiency. However, when the water vapor concentration is less than or equal to 10 ppm, the defect passivation is not sufficient under light irradiation and the conductivity of PTAA is lower, which results in lower hole transport efficiency, and thus carrier recombination caused by defect levels seems to have degraded the solar cell characteristics. The decrease rate in efficiency was greater when the additive for PTAA was lithium bis(trifluoromethanesulfonyl)imide (LiTFSI). LiTFSI is doped in a smaller amount than TPFPB, which is a strong acceptor molecule, as an additive. This allows the resistance of PTAA to largely increase when the water vapor concentration is low, and the recombination due to the degradation of the perovskite compound seems to have had a large impact.

### <Effect of Water Vapor Concentration on Solar Cell Characteristics After Heat Resistance Test>

As indicated in Table 1 and Figs. 5 and 7, the photoelectric conversion efficiency after the heat resistance test is high when the water vapor concentration in the sealed space is greater than or equal to 100 ppm and less than or equal to 5000 ppm. When the water vapor concentration is 10 ppm, which is in the low water vapor concentration region, the decrease rate in the photoelectric conversion efficiency is large. The optimal water vapor concentration range exists for the same reason for the light resistance test and the heat resistance test. However, unlike in the case of the light resistance test, in the case of the heat resistance test, the decrease rate in the photoelectric conversion efficiency was large when the additive was tris(pentafluorophenyl)borane. This may be resulted from the decrease in the doping ability of tris(pentafluorophenyl)borane caused by heating, which enhances the difference in conductivity improvement effect of moisture on PTAA. Thus, when the energy of light irradiated in the light resistance test and the heating temperature in the heat resistance test are increased, new defects may be generated depending on the activation energy to generate various defects. In addition, if the water vapor concentration is small, the conductivity of PTAA is lowered. This decreases the hole extraction efficiency, which increases the defect recombination rate and lowers the photo electric conversion efficiency. However, the conditions for the light resistance test and the heat resistance test in Examples were set for actual outdoor operation. Thus, the optimal water vapor concentration range found by using Examples for improving the durability of solar cell will remain the same.

From the above results, it was confirmed that the solar cell of the present disclosure can have both the photostability and the thermal stability when the water vapor concentration in the sealed space is greater than or equal to 100 ppm and less than or equal to and 5000 ppm.

### Industrial Applicability

This disclosure can significantly improve the durability of solar cells and has remarkably high industrial applicability. Reference Signs List

1 photoelectric conversion element
2 support
3 sealing member
4 substrate
5 first electrode
6 electron transport layer
7 photoelectric conversion layer
8 hole transport layer
9 second electrode
10 porous layer
11 intermediate layer
100, 200, 300 photoelectric conversion element
1000 solar cell

## Claims

1. A solar cell comprising:
a support;
a photoelectric conversion element; and
a sealing member, wherein
the photoelectric conversion element is in a sealed space defined by the support and the sealing member,
the photoelectric conversion element includes, in this order, a first electrode, a photoelectric conversion layer, and a second electrode,
an oxygen concentration in the sealed space is less than 10 ppm in terms of volume fraction, and
a water vapor concentration in the sealed space is greater than or equal to 100 ppm and less than or equal to 5000 ppm in terms of volume fraction.

2. A solar cell comprising:
a support;
a photoelectric conversion element; and
a sealing member, wherein
the photoelectric conversion element is in a sealed space defined by the support and the sealing member,
the photoelectric conversion element includes, in this order, a first electrode, a photoelectric conversion layer, and a second electrode,
an oxygen concentration in the sealed space is less than 10 ppm in terms of volume fraction, and
a value obtained by dividing a water vapor content in the sealed space by an area of a surface of the photoelectric conversion element facing the sealed space is greater than or equal to 2.3 ×10⁻⁶ mol/m² and less than or equal to 1.2 × 10⁻⁴ mol/m².

3. The solar cell according to claim 1, wherein the water vapor concentration in the sealed space is greater than or equal to 100 ppm and less than or equal to 1000 ppm in terms of volume fraction.

4. The solar cell according to claim 2, wherein the value obtained by dividing the water vapor content in the sealed space by the area of the surface of the photoelectric conversion element facing the sealed space is greater than or equal to 2.3 × 10⁻⁶ mol/m² and less than or equal to 2.3 × 10⁻⁵ mol/m².

5. The solar cell according to any one of claims 1 to 4, wherein a partial pressure of water vapor in the sealed space is greater than or equal to 1 × 10⁻⁴ atm and 5 × 10⁻³ atm.

6. The solar cell according to any one of claims 1 to 5, wherein the photoelectric conversion layer contains a perovskite compound.

7. The solar cell according to claim 6, wherein the perovskite compound contains lead.

8. The solar cell according to any one of claims 1 to 7, wherein the photoelectric conversion element further includes a hole transport layer located between the photoelectric conversion layer and the second electrode, and
the hole transport layer contains an organic semiconductor.

9. The solar cell according to claim 8, wherein the organic semiconductor contains at least one selected from the group consisting of 2,2',7,7'-tetrakis-(N,N-di-p-methoxyphenylamine)9,9'-spirobifluorene and poly[bis(4-phenyl)(2,4,6-trimethylphenyl)amine].

10. The solar cell according to claim 8 or 9, wherein the hole transport layer further contains an additive.

11. The solar cell according to claim 10, wherein the additive contains at least one selected from the group consisting of tert-butylpyridine, bis(trifluoromethanesulfonyl)imide calcium(II), bis(trifluoromethanesulfonyl)imide zinc(II), tris[4-tert-butyl-2-(1H-pyrazol-1-yl)pyridine] cobalt(III) tris(trifluoromethanesulfonyl)imide, and tris(pentafluorophenyl)borane.

12. A method of producing a solar cell comprising performing sealing of a photoelectric conversion element that includes, in this order, a first electrode, a photoelectric conversion layer, and a second electrode in an atmosphere having an oxygen concentration of less than 10 ppm in terms of volume fraction and a water vapor concentration of greater than or equal to 100 ppm and less than or equal to 5000 ppm in terms of volume fraction.
